# EUROPEAN PATENT SPECIFICATION

(11) **EP 1 357 582 B1**
(45) Date of publication and mention of the grant of the patent: **13.12.2006**
(21) Application number: 01978878.5
(22) Date of filing: 24.10.2001
(51) Int. Cl.: H01L 21/205, G01L 19/06, F27B 17/00, F27D 7/02, C30B 33/00, H01L 21/00

(54) **HEAT-TREATING DEVICE**
WÄRMEBEHANDLUNGSEINRICHTUNG
DISPOSITIF DE TRAITEMENT THERMIQUE

(30) Priority: 27.10.2000 JP 2000328017; 29.01.2001 JP 2001019341; 29.01.2001 JP 2001019342
(43) Date of publication of application: 29.10.2003
(73) Proprietor: TOKYO ELECTRON LIMITED, Minato-ku, Tokyo 107-8481 (JP)
(72) Inventor: SAITO, Yukimasa, Tsukui-gun, Kanagawa 220-0101 (JP)
(74) Representative: Liesegang, Eva
(86) International application number: PCT/JP2001/009331
(87) International publication number: WO 2002/035590

(56) References cited:
- EP-A- 1 235 262
- JP-A- 3 223 418
- JP-A- 7 072 029
- JP-A- 11 151 418
- JP-A- 11 214 489
- JP-A- 2000 189 782
- PATENT ABSTRACTS OF JAPAN vol. 1999, no. 13, 30 November 1999 (1999-11-30) & JP 11 233505 A (TOKYO ELECTRON LTD), 27 August 1999 (1999-08-27)
- PATENT ABSTRACTS OF JAPAN vol. 1996, no. 09, 30 September 1996 (1996-09-30) & JP 8 139085 A (NIPPON STEEL CORP), 31 May 1996 (1996-05-31)

## Description

### FIELD OF THE INVENTION

This invention relates to a thermal processing unit.

### BACKGROUND OF THE INVENTION

For example, in a manufacturing process of a semiconductor device, as a thermal processing, there is an oxidation step wherein an oxide film is formed on a surface of a semiconductor wafer, which is an object to be processed. As a method for the oxidation treatment, there is a method to bring a semiconductor wafer into contact with water vapor at a predetermined process temperature and thus to oxidize the same (wet oxidization). In order to carry out the method, there is known an oxidation processing unit (a thermal processing unit) wherein a burning unit that causes hydrogen gas and oxygen gas to react (burn) to generate water vapor is independently arranged outside a processing furnace, and wherein the water vapor generated by the burning unit is supplied into the processing furnace to carry out a heat treatment, as shown in JP Laid-Open Publication No.63-210501 or the like.

In addition, as a thermal processing unit, there are a normal-pressure type of unit having a normal-pressure gas-discharging system and another type of unit, by which a treatment can be carried out under a reduced pressure, having a normal-pressure gas-discharging system and a reduced-pressure gas-discharging system.

In a conventional normal-pressure type of thermal processing unit, a discharging-pressure-controlling valve, which is a butterfly-valve type or another type of adjusting its own opening degree via a stepping motor and a spring, and a differential-pressure type of pressure sensor are provided in a normal-pressure gas-discharging system that discharges inside gas from a processing furnace at a predetermined discharging-pressure, in order to control the discharging-pressure.

On the other hand, in a conventional reduced-pressure type of thermal processing unit, by which a treatment can be carried out under a reduced pressure, a gas-discharging system from a processing furnace branches into a normal-pressure gas-discharging system and a reduced-pressure gas-discharging system. A switching valve is provided at the branching portion, and the discharging-pressure-controlling valve and the pressure sensor, which are described above, are provided in the normal-pressure gas-discharging system in order to control the discharging-pressure. In addition, a combination valve and a pressure sensor are provided in the reduced-pressure gas-discharging system in order to carry out a reduced-pressure control.

However, in both the normal-pressure type of thermal processing unit and the reduced-pressure type of thermal processing unit, if the discharging-pressure-controlling valve is a butterfly-valve type, the water vapor may condense to generate a water screen between the valve and a pipe, which may make the control unstable. Thus, in order to avoid the above disadvantage, it was necessary to provide atmospheric-air-introducing ports on the front side and the rear side of the valve. In addition, if the discharging-pressure-controlling valve is another type of valve which adjusts its own opening degree via a stepping motor and a spring, in order to make the motion of the valve smooth and hence to make the control performance stable, it was necessary to introduce an inert gas such as N₂ gas toward the valve. Thus, running-costs for the inert gas were necessary. In addition, in the reduced-pressure type of thermal processing unit, the switching valve is necessary, which leads to structural complication.

On the other hand, recently, as the semiconductor devices have been made more minutely, there are requests of reduced-pressure process in an oxidation processing unit, requests of sequential process of an oxidation treatment and a CVD treatment by means of a CVD unit, and so on. For example, in a wet-oxidation treatment, a wet-HCl-oxidation treatment, a sequential process of a wet-oxidation treatment and a CVD treatment of SiCl₄, or the like, a conventional pressure sensor made of metal may be subjected to strong-corrosion environment by a chlorine corrosion gas and moisture. Thus, it is becoming difficult to use the conventional pressure sensor made of metal.

In addition, conventionally, a normal-pressure gas-discharging system and a reduced-pressure gas-discharging system that have been mainly formed by Teflon pipes are provided in an oxidation processing unit. In addition, conventionally, a reduced-pressure gas-discharging system that has been mainly formed by stainless-steel pipes is provided in a CVD unit.

Recently, there is a request that desires to serially conduct an oxidation treatment and a CVD treatment by means of the same unit

However, if a CVD treatment is conducted in an oxidation processing unit wherein Teflon pipes are used for its gas-discharging system, since apertures of the pipes are limited because of cost or the like, discharging conductance may be short and/or a vacuuming operation may be unsuitable because of poor gas-permeability of the pipes.

In addition, if an oxidation treatment is conducted in a CVD unit wherein stainless-steel pipes are used for its gas-discharging system, there may be generated a problem that inside surfaces of the pipes may be corroded by a process gas. Especially, when an oxidation treatment and a CVD treatment are serially conducted, the inside surfaces may be subjected to strong-corrosion environment by a chlorine corrosion gas and moisture. Thus, sure measures against attachment of by-products on the inside surfaces of reaction pipes in a CDV treatment have been desired.

In addition, in the thermal processing units, the processing furnace is made of quartz. However, the furnace lid, the manifold and so on, which are difficult to machine, are made of metal. Thus, in order to prevent metal-contamination on the wafer, some measures may be conducted. For example, the above metal elements may be covered by quartz, and/or an inert gas may be locally supplied to the above metal elements, in order to prevent metal parts from coming in contact with a gas in the furnace. In these cases, as a quartz cover is provided or the inert gas is supplied, structure of the unit may be complicated, which may increase cost.

In addition, there is known an oxidation processing unit having a normal-pressure gas-discharging system wherein a tip point of its discharging pipe is connected to a factory discharging system and a pressure in its processing container can be reduced to a slightly reduced pressure in the vicinity of atmospheric pressure and maintained at the slightly reduced pressure during a treatment.

However, in the conventional unit wherein the pressure in the processing container is controlled only by means of vacuum pressure of the factory discharging system, since the vacuum pressure is weak (discharging ability is low), range of the pressure control is small. In addition, if there is a change of atmospheric pressure, the pressure is not controlled stably.

Furthermore, in the conventional unit, the pressure in the processing container is controlled based on a difference pressure with respect to the atmospheric pressure. Thus, if the atmospheric pressure changes, the pressure in the processing container may be also changed slightly. In the case, there is a possibility that a film thickness of an object to be processed may be changed.

### SUMMARY OF THE INVENTION

This invention is intended to solve the above problems. The object of this invention is to provide a thermal processing unit wherein a stable control can be achieved without necessity of introducing atmospheric air or introducing any inert gas, wherein a structure of the gas-discharging system is simplified, wherein reduction of costs is achieved, wherein there is no concern about corrosion of a pressure sensor even in severe corrosion environment, and wherein a stable process can be achieved at.any time.

The present invention provides a thermal processing unit according to claim 1. Preferred embodiments of hte invention are defined in dependent claims 2 to 10.

According to the feature, a stable control can be achieved without necessity of introducing atmospheric air or introducing any inert gas. In addition, a structure of the gas-discharging system is simplified, reduction of costs is achieved, there is no concern about corrosion of the pressure sensor even in severe corrosion environment, and a stable process can be achieved at any time.

According to the invention, in comparison with a conventional pressure-controlling method us ing only a factory discharging system, a stable pressure control can be achieved within a wider range.

### BRIEF DESCRIPTION OF THE DRAWINGS

Fig. 1 is a structural view showing an oxidation treatment unit of a first embodiment according to the invention;
Fig. 2 is a schematic sectional view of an absolute-pressure type of pressure sensor;
Fig. 3 is a structural view showing an oxidation treatment unit of a second embodiment according to the invention;
Fig. 4 is a structural view showing an oxidation treatment unit of a third embodiment which is not part of the invention, and
Fig. 5 is a structural view showing an oxidation treatment unit of a fourth embodiment according to the invention.

### DESCRIPTION OF THE PREFERRED EMBODIMENT

Embodiments of the invention are explained in detail based on attached drawings.

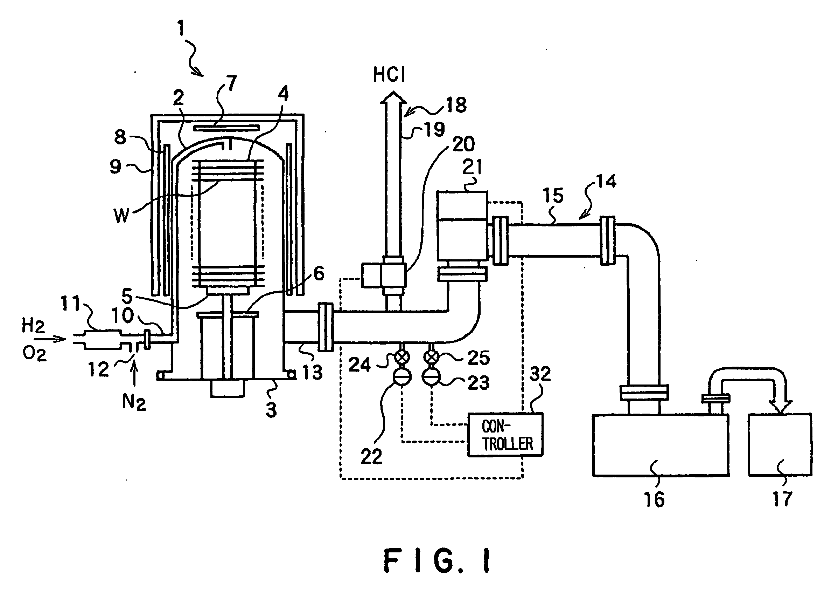

Fig. 1 is a view showing a structure of an oxidation treatment unit of a first embodiment according to the invention. The oxidation treatment unit (a thermal processing unit) of the embodiment is formed as a normal-pressure type of unit. In Fig. 1, a processing furnace 1, which is vertical and batch type, is adapted to contain semiconductor wafers W as objects to be processed, and to conduct a heat treatment to the semiconductor wafers W at a high temperature such as about 850°C while water vapor as a process gas is supplied thereinto. The processing furnace 1 has a reaction tube (processing container) 2, whose upper end is closed, whose lower end is open, which has a longitudinal cylindrical shape and a heat resistance, and which is made of for example quartz.

The reaction tube 2 is adapted to form the processing furnace 1 with a high airtightness when an opening at a lower end thereof as a furnace opening is hermetically closed by a lid 3. A wafer-boat 4, which is made of for example quartz, as a substrate holder for holding many, for example about 150 horizontal semiconductor wafers W in a vertical tier-like manner at intervals, is placed on the lid 3 via a rotatable heat insulating cylinder 5. A lower plate-like heating element 6 is provided on the lid 3 so as to prevent heat radiation from the furnace opening. An upper plate-like heating element 7 is provided above the reaction tube 2 and can heat the semiconductor wafer W uniformly within a surface thereof.

The lid 3 is adapted to load (convey) the wafer boat 4 into the processing furnace 1, unload (convey) the wafer boat 4 from the processing furnace 1, and open and close the furnace opening, by means of an elevating mechanism not shown. A heater 8 that can heat and control the inside of the processing furnace to a predetermined temperature, for example 300 to 1000 °C, is provided around the reaction tube 2. The heater 8 consists of a resistance heating element. It is preferable that the heater 8 can rapidly raise and drop the temperature. The heater 8 is surrounded by a cooling jacket 9.

A suitable number of gas-introducing pipes 10 is provided at a lower portion of the reaction tube 2. One of the gas-introducing pipes 10 is connected to a burning unit 11 that generates water vapor by a burning reaction between hydrogen gas H₂ and oxygen gas O₂ and that supplies the water vapor as process-gas supplying means (water-vapor supplying means).

Preferably, the burning unit 11 is formed to be able to supply the water vapor at a minute flow rate, for example of 0.4 to 1 liter per minute (3 liter or more per minute according to prior art), by reducing the aperture of a burning nozzle or improving the shape of the burning nozzle or the like. In addition, an inert-gas supplying part 12 that supplies an inert gas such as nitrogen gas N₂ is provided in the burning unit 11, in order to dilute the water vapor. The others of the gas-introducing pipes 10 are respectively connected to gas sources that supply other process gases such as nitrogen oxide gas NO, dinitrogen oxide gas N₂O and hydrogen chloride gas HCl, or inert gas such as N₂ (omitted in the drawings).

A gas-discharging pipe (pipe-port) 13 is provided at a lower side wall of the reaction tube 2 for discharging gas present inside the reaction tube 2. A gas-discharging pipe 15 forming a reduced-pressure gas-discharging system 14 is connected to the gas-discharging pipe 13. The gas-discharging pipe 15 consists of a pipe having a large inside diameter, for example of about 3 inch, so that a reduced-pressure gas-discharging operation can be conducted under a high degree of vacuum. In addition, the pipe forming the gas-discharging pipe 15 is corrosion-resistant. For example, if the pipe is made of metal (preferably, made of stainless-steel), the inside surface of the pipe is coated with a corrosion-resistant resin, preferably a fluorine resin. A pressure-reducing pump (vacuum pump) 16 that can create a vacuum of for example about -1 Pa at the maximum in the processing furnace 1 is connected to a downstream end of the gas-discharging pipe 15. A harm-removing unit 17 is connected to a downstream side of the pressure-reducing pump 16. It is preferable that the pressure-reducing pump 16 is for example a dry-sealed vacuum pump.

A normal-pressure gas-discharging pipe 19, which forms a normal-pressure gas-discharging system 18 communicating with a gas-discharging duct (not shown) of a factory gas-discharging system including a harm-removing unit and/or a gas-discharging blower, branches off on the way of the gas-discharging pipe 15. Thus, an operation under a normal pressure or a slightly reduced pressure can be conducted. The normal-pressure gas-discharging pipe 19 consists of a corrosion-resistant pipe, similarly to the gas-discharging pipe 15. Preferably, heating means such as a resistant heating element is arranged around the outside peripheries of the gas-discharging pipe 15 and the normal-pressure gas-discharging pipe 19, in order to evaporate moisture in the pipes that may cause corrosion.

In the normal-pressure gas-discharging system 18 and the reduced-pressure gas-discharging system 14, combination valves 20 and 21, which are adjustably caused to open and close and whose pressures are also adjustable, are provided respectively. In the reduced-pressure gas-discharging system 14, the combination valve 21 is mounted in the gas-discharging pipe 15 at a downstream portion with respect to the branching-connecting portion of the normal-pressure gas-discharging pipe 19. For example, each of the combination valves 20, 21 may convert an electric signal into an air pressure, in order to control the position of a valve body (not shown). In addition, each of the combination valves 20, 21 has an O-shaped ring (not shown) at a seating portion for the valve body, so that the combination valves 20, 21 can shut off. It is preferable that the combination valves 20, 21 are made of a corrosion-resistance material such as a fluorine resin. Alternatively, it is preferable that a gas-contact surface that may come in contact with the discharged gas is coated by a fluorine resin film.

A pressure sensor 22 that detects a gas-discharging pressure while a treatment is carried out under a normal pressure and a pressure sensor 23 that detects a gas-discharging pressure while a treatment is carried out under a reduced pressure (while the gas is discharged under a reduced pressure) are respectively provided via air-pressure-control type of valves 24 and 25 at upstream portions of the gas-discharging pipe 15 with respect to the combination valve 21 for the treatment under a reduced pressure. For example, the pressure sensor 22 can detect a pressure within a range of 0 to 133 kPa (0 to 1000 Torr). For example, the pressure sensor 23 can detect a pressure within a range of 0 to 1.33 kPa (0 to 10 Torr). As the pressure sensors 22 and 23, absolute-pressure type of pressure sensors may be used. Since the pressure sensor 22 can always detect a pressure within the wide range, it may be unnecessary to arrange the valve 24.

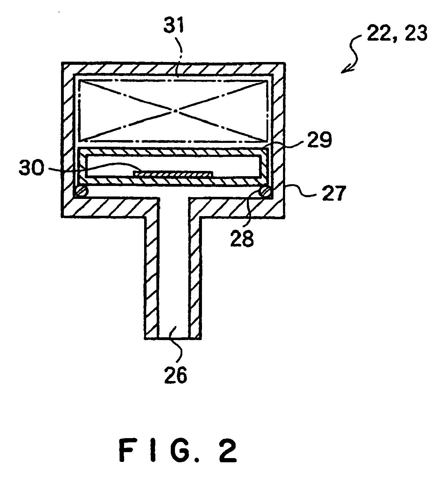

Regarding the pressure sensors 22, 23, each gas-contact surface that may come in contact with the discharged gas is made of a corrosion-resistant material that is not metal, in order to enable the pressure sensors to be used in severe corrosion environment wherein moisture and a corrosive gas exit. In detail, as shown in Fig. 2, each of the pressure sensors 22, 23 has: a main body 27 made of a fluorine resin or a ceramic and having a communicating part 26 to the gas-discharging pipe 15 and an inside part formed enlargedly; and a pressure-receiving member 29 made of a ceramic hermetically provided in the inside part of the main body 27 on the gas-discharging side via an O-shaped ring 28 made of a fluorine resin as a circular sealing member. The pressure-receiving member 29 is formed in a hollow box-like shape. The inside of the pressure-receiving member 29 is maintained at a vacuum by means of a getter agent. A sensor member 30 is attached in a strained manner on an inside surface of the pressure-receiving member 29, in order to detect an amount of deformation distortion caused by the discharging-pressure as an electric quantity. Furthermore, an electric equipment 31 is provided in the main body 27.

The combination valves 20 and 21, which are provided in the normal-pressure gas-discharging system 18 and in the reduced-pressure gas-discharging system 14, respectively, are adapted to be controlled by the common controlling part (controller) 32, based on the pressures detected by the pressure sensors 22 and 23. In detail, for an operation under a normal pressure, the controlling part 32 causes the combination valve 20 in the normal-pressure gas-discharging system 18 to open, and controls the same based on the pressure detected by the pressure sensor 22 that is provided for the operation under a normal pressure. In addition, for an operation under a reduced pressure, the controlling part 32 causes the combination valve 21 in the reduced-pressure gas-discharging system 14 to open, and controls the same based on the pressure detected by the pressure sensor 23 that is provided for the operation under a reduced pressure. That is, two control systems can be achieved.

The oxidation treatment unit consisting of the above compositions has a leak-tight structure in which the gas can be discharged at a highly reduced pressure. For example, sealing means such as an O-shaped ring is provided at each connecting part in the gas-discharging system from the processing furnace 1. In addition, the thermal processing unit is adapted to automatically carry out a desired thermal processing method, by controlling the burning unit 11, the heater 8, the controlling parts of the combination valves 20 and 21, and so on through a controlling unit (not shown) in which a program recipe for the desired thermal processing method has been inputted in advance.

Next, an operation of the above oxidation treatment unit (a thermal processing method) is explained. At first, the inside of the processing furnace 1 is open to the atmosphere, and is heated and controlled at a predetermined temperature such as 300 °C by the heater 8. The wafer boat 4 holding many semiconductor wafers W is loaded into the processing furnace 1. The furnace opening of the processing furnace 1 is hermetically closed by the lid 3. After that, the pressure in the processing furnace 1 is reduced by a vacuuming operation of the reduced-pressure gas-discharging system 14. Preferably, the pressure-reducing or vacuuming operation includes a cycle-purging step. During the loading step and the cycle-purging step, an inert gas such as N₂ is supplied into the processing furnace 1 in order to prevent that a natural oxidation film is formed on surfaces of the semiconductor wafers W. On the other hand, if the N₂ is 100 %, the surfaces of the semiconductor wafers W may be nitrified. The nitrified surfaces are difficult to be oxidized at a subsequent oxidizing step. Thus, a small amount of oxygen, for example about 1 % of oxygen is supplied during the loading step and the cycle-purging step.

The cycle-purging step is carried out by repeating supply and stop of the inert gas such as N₂ by turns while the inside of the processing furnace 1 is vacuumed. In the case, the gas-discharging system is switched into the reduced-pressure gas-discharging system 14 by means of the combination valve 21. In addition, while the vacuum pump 16 is in operation, a pressure (a pressure in the tube = a pressure in the furnace 1) is detected by the pressure sensor 23. In addition, gas in the processing furnace 1 is discharged through a control of the combination valve 21 in such a manner that a pressure in the processing furnace 1 becomes a predetermined pressure such as about -1 Pa. In the reduced-pressure gas-discharging condition, an inert gas such as N₂, whose flow rate is controlled at a predetermined rate, is intermittently supplied by repeating opening and shutting an inert-gas-supplying valve (not shown). Thus, the cycle-purging step is carried out, the pressure in the processing furnace 1 is rapidly reduced, and the gas in the processing furnace 1 is replaced with the inert gas sufficiently. That is, rapid reduction of the pressure (shortening of a time until a predetermined vacuum is created) and gas-replacement can be achieved by the cycle-purging step.

Next, in the above reduced-pressure gas-discharging condition, the atmosphere in the processing furnace 1 is heated to a predetermined process temperature such as 850 °C via a control of the heater 8. As the gas-discharging system is switched into the normal-pressure gas-discharging system 18 by means of the combination valve 20, the pressure in the processing furnace 1 is controlled to a normal pressure (a pressure reduced by about 1 Torr) or a slightly reduced pressure (a pressure reduced by about 100 to 200 Torr). In the state, a recovery step (a step for stabilizing semiconductor-wafer temperature) is carried out, and then a predetermined heating process such as an HCl oxidation treatment is carried out. The heating treatment is carried out under a slightly reduced pressure, by supplying oxygen gas O₂ and hydrogen gas H₂ into the burning unit 11 to cause them to burn, and by supplying water vapor generated in the burning unit 11 into the processing furnace 1 together with hydrogen chloride gas HCl and an inert gas such as N₂.

After the heating processing step is completed, the gas-discharging system is switched into the reduced-pressure gas-discharging system 14 (automatic switching), so that the inside of the processing furnace 1 is vacuumed again to reduce the pressure therein. After that, through a control of the heater 8, a temperature of the inside of the processing furnace 1 is reduced to a predetermined temperature such as about 300°C. At the same time, the pressure in the processing furnace 1 is returned to a normal pressure, the wafer boat 4 is unloaded from the processing furnace 1, and a cooling step (wherein the semiconductor wafers are cooled to a conveyable temperature) is carried out. Preferably, the second pressure-reducing and vacuuming operation after completing the heating processing step also includes a cycle-purging step.

As described above, the semiconductor wafers W are contained in the processing furnace 1 that have been already heated to a predetermined temperature, the inside atmosphere in the processing furnace 1 is heated to a predetermined process temperature, and water vapor as a process gas is supplied in order to thermally process the semiconductor wafers W, wherein the heating step of the inside atmosphere is carried out under a reduced pressure. Thus, the semiconductor wafers W can be heated to the predetermined process temperature under a condition wherein oxidation species are excluded. Thus, it can be prevented that a natural oxidation film is formed during the heating step, so that a very-thin oxidation film whose quality is excellent can be formed.

In addition, not only before the predetermined heat treatment step but also after the same step, the inside in the processing furnace 1 is vacuumed to reduce the pressure therein. Thus, surplus oxidation species are sufficiently excluded except for in the desired heat treatment step, so that it can be sufficiently prevented that a natural oxidation film is formed. Thus, a very-thin oxidation film whose thickness is uniform and whose quality is uniform and excellent can be formed. For example, an SiO₂ film whose thickness is for example about 2 nm can be formed.

If the step of reducing the pressure in the processing furnace 1 or of vacuuming the processing furnace 1 includes what is called a cycle-purging step, rapid pressure-reduction and gas-replacement can be achieved, which can improve throughput.

In addition, the heat treatment unit comprises: the burning unit 11 that is water vapor supplying means for supplying the water vapor into the processing furnace 1; the normal-pressure gas-discharging system 18 that discharges the gas from the processing furnace 1 during the heat treatment step under a minute differential pressure or a minute reduced pressure; and the reduced-pressure gas-discharging system 14 that can vacuum the inside of the processing furnace 1 before and after the heat treatment step; wherein the switching operation between the normal-pressure gas-discharging system 18 and the reduced-pressure gas-discharging system 14 are carried out by means of the combination valves 20 and 21. Thus, the above thermal processing method can be carried out surely and easily.

In the case, the burning unit 11 is formed to be able to supply the water vapor at a minute flow rate. Thus, if a sufficient film-forming time is taken, a very-thin oxidation filmwhose quality is more excellent can be formed. In addition, since the combination valves 20 and 21 have an opening-and-shutting function and a pressure-adjusting function, the number of valves can be reduced, so that structures of the normal-pressure gas-discharging system 18 and the reduced-pressure gas-discharging system 14 can be simplified, which can lead to reduction of costs.

In addition, as an oxidation treatment method, a diffusion treatment can be carried out by supplying nitrogen oxide gas NO or dinitrogen oxide gas N₂O under a condition wherein the pressure in the processing furnace 1 is reduced and controlled to a predetermined pressure such as about 133 hPa, after a desired oxidation treatment step. Before and after the diffusion processing step, the inside of the processing furnace 1 is preferably vacuumed to reduce the pressure therein. In addition, preferably, the pressure-reducing and vacuuming operation includes a cycle-purging step. As described above, if the water component in the processing furnace is sufficiently removed by the cycle-purging step after the wet-oxidation treatment and then the nitrogen oxide gas NO or the dinitrogen oxide gas N₂O are supplied, it can be sufficiently prevented that nitric acid HNO₃ with strong corrosiveness is generated. In addition, an SiON film having high insulation resistance can be formed, that is, improvement to a more reliable film-quality can be easily achieved.

Thus, the reduced-pressure type of oxidation treatment unit, by which a treatment can be carried out under a reduced pressure, is for supplying the process gas into the processing furnace 1 that contains the semiconductor wafers W and for thermally processing the semiconductor wafers W at a predetermined process temperature. Then, the reduced-pressure type of oxidation treatment unit has: the normal-pressure gas-discharging system 18 for discharging the gas from the processing furnace 1 at a predetermined discharging-pressure; the reduced-pressure gas-discharging system 14 for discharging the gas from the processing furnace 1 at another discharging-pressure lower than that by the normal-pressure gas-discharging system 18; the combination valves 20 and 21 provided in the normal-pressure gas-discharging system 18 and the reduced-pressure gas-discharging system 14, respectively, and adjustably caused to open and close, the pressures of the valves being also adjustable; the differential-pressure type or absolute-pressure type of pressure sensors 22 and 23 that detect the discharging-pressure; and the controller 32 that controls the combination valves 20 and 21 based on the pressures detected by the pressure sensors 22 and 23.

Thus, an oxidation treatment under a normal pressure or a slightly reduced pressure by means of the normal-pressure gas-discharging system 18 and a cycle-purging operation, a CVD treatment under a reduced pressure or the like by means of the reduced-pressure gas-discharging system 14 can be serially conducted. In the normal-pressure gas-discharging system 18, a stable control can be achieved without necessity of introducing atmospheric air or introducing any inert gas. In addition, the structure of the gas-discharging system is simplified, and running-costs for the inert gas such as N₂ become unnecessary, so that reduction of costs for the whole unit is achieved.

Especially, if absolute-pressure type of pressure sensors 22 and 23 are used as the pressure sensor in the normal-pressure gas-discharging system 18 and the pressure sensor in the reduced-pressure gas-discharging system 14, a stable absolute-pressure control in a vicinity of the atmospheric pressure and a stable absolute-pressure control under a reduced pressure can be achieved, without disturbance caused by change in the atmospheric pressure based on the meteorological condition. Thus, an oxide film having a uniform thin film-thickness can be formed at any time.

In the above oxidation treatment unit, it is unnecessary to introduce atmospheric air or any inert gas on the front side and the rear side of the combination valve of the normal-pressure gas-discharging system. However, the oxidation treatment unit can be formed in such a manner that atmospheric air or any inert gas can be introduced thereon. As the absolute-pressure type of pressure sensor 22, for example, a pressure sensor that can detect a pressure within a range of 800 to 1100 hPa may be used. In the embodiment shown in Fig. 1, two absolute-pressure type sensors 22 and 23 having different ranges are used. However, if a high accurate pressure control under a reduced pressure is not required, the absolute-pressure type of pressure sensor 23 that has a narrower range becomes unnecessary, that is, the absolute-pressure type of pressure sensor 22 that has a wider range is sufficient.

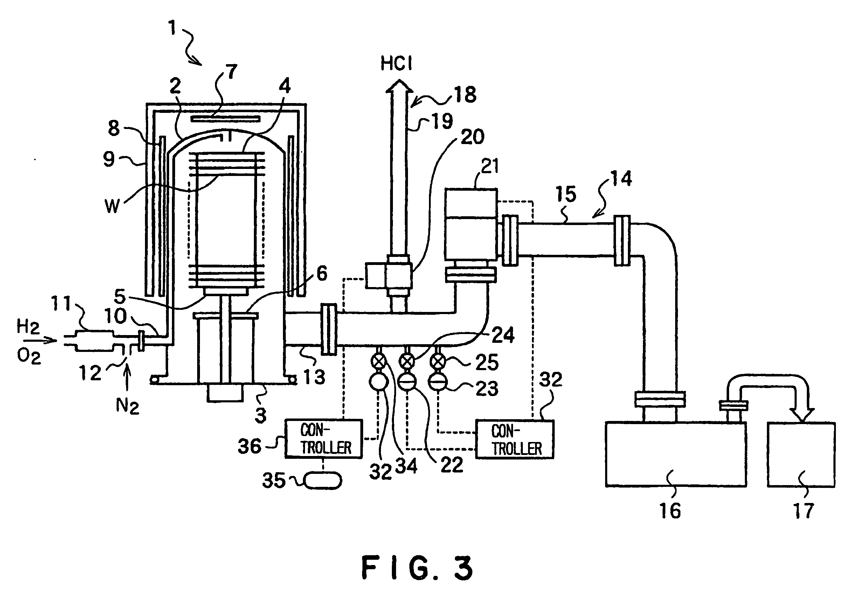

Fig. 3 is a view showing a structure of an oxidation treatment unit of a second embodiment according to the invention. In the second embodiment, the same numeral references correspond to the same parts as the first embodiment. The explanation of the same parts is omitted.

In the oxidation treatment unit of the second embodiment, in order to control the combination valve 20 provided in the normal-pressure gas-discharging system 18, a differential-pressure type of pressure sensor 33 that detects the discharging-pressure as a differential pressure with respect to the atmospheric pressure is provided in the gas-discharging pipe 15 via an air-pressure-control type of valve 34. In addition, in order to control the combination valve 20, provided are an absolute-pressure type of pressure sensor (atmospheric-pressure sensor) 35 that detects the atmospheric pressure as an absolute pressure, and a controller 36 that controls the combination valve 20 based on the pressure detected by the differential-pressure type of pressure sensor 33 in such a manner that the discharging-pressure in the normal-pressure gas-discharging system 18 coincides with a set differential pressure and that amends the set differential pressure based on the pressure detected by the absolute-pressure type of pressure sensor 35.

As the differential-pressure type of pressure sensor 33, for example, a pressure sensor that can detect a pressure within a range of the atmospheric pressure (1013.25 hPa) ± 1330 Pa may be used. Regarding the differential-pressure type of pressure sensor 33, in order for it to endure the severe corrosion environment, one or more gas-contact surfaces that may come in contact with the discharged gas are made of a corrosion-resistant material that is not metal, for example a corrosion-resistant resin, preferably a fluorine resin. In the case, it is preferable that the differential-pressure type of pressure sensor 33 has a main body made of a fluorine resin or a ceramic and a pressure-receiving member made of a ceramic hermetically provided in the main body, similarly to the embodiment shown in Fig. 1. In addition, in the case, a hollow portion of the pressure-receiving member is open to the atmosphere.

As the absolute-pressure type of pressure sensor 35, for example, a general pressure sensor that can detect a pressure within a range of 0 to 1330 hPa (0 to 1000 Torr) may be used. Alternatively, as the absolute-pressure type of pressure sensor 35, for example, a pressure sensor that can detect a pressure within a range of 800 to 1100 hPa may be used.

According to the embodiment of Fig. 3, in the normal-pressure gas-discharging system, a signal from the absolute-pressure type of pressure sensor 35 that always monitors the atmospheric pressure is inputted into the controller 36, and the set pressure (the set differential pressure) is adjusted in accordance with the change in the atmospheric pressure, so that the process can be conducted always under a constant pressure. Thus, even by a differential-pressure control, regardless of any change in the atmospheric pressure (weather), a stable control can be achieved so that an oxidation film having a uniform film-thickness can be formed at any time.

For example, when an average atmospheric pressure where the oxidation treatment unit is installed is 1013.25 hPa (760 Torr) and a process pressure (a set pressure) is also 1013.25 hPa (760 Torr), that is, a set differential pressure is 0 Pa (0 Torr), if there is no change in the atmospheric pressure, the combination valve 20 is controlled by the controlling part 36, based on the pressure detected by the differential-pressure type of pressure sensor 33, in such a manner that the discharging-pressure in the normal-pressure gas-discharging system 18 coincides with the set differential pressure 0 Pa.

However, if the atmospheric pressure is changed to 997.5 hPa (750 Torr) because of a change in the weather, for example, because of approach of a cyclone, the discharging-pressure in the normal-pressure gas-discharging system 18 might be controlled to coincide with 997.5 hPa (750 Torr) through the control only by means of the differential-pressure type of pressure sensor 33, because the set differential pressure is 0 Pa (0 Torr). In that case, the film-thickness of an oxidation film that is formed on the surface of a semiconductor wafer may be changed.

Thus, the atmospheric pressure at that time 997.5 hPa (750 Torr) is detected by the absolute-pressure type of pressure sensor 35, the detected signal is inputted into the controlling part 36, and the set differential pressure 0 Pa (0 Torr) is amended to +15.75 hPa (+11.84 Torr). Accordingly, the discharging-pressure in the normal-pressure gas-discharging system 18 can be controlled to coincide with 1013.25 hPa (760 Torr). That is, since a set differential pressure when setting (a set pressure - an atmospheric pressure when setting) can be amended to a differential pressure at that time (the set pressure - an atmospheric pressure at that time), the discharging-pressure in the normal-pressure gas-discharging system 18 i.e. the process pressure in the processing furnace 1 can be always maintained at a fixed level, regardless of any change in the weather i.e. regardless of any change in the atmospheric pressure. Thus, the film-thickness of an oxidation film can be made uniform.

In the embodiment, the pressure sensor (atmospheric-pressure sensor) 35 that detects the atmospheric pressure as an absolute pressure may be a barometer.

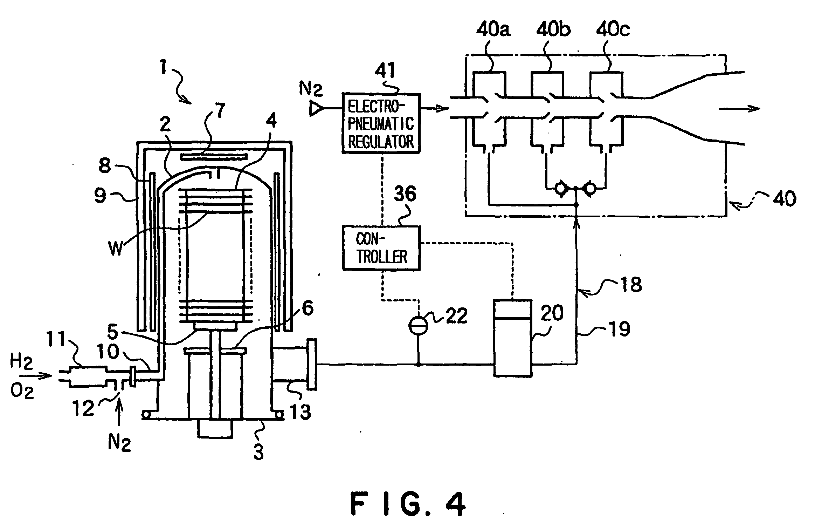

Fig. 4 is a view showing a structure of an oxidation treatment unit of a third embodiment The oxidation treatment unit (a thermal processing unit) of the embodiment is formed as a normal-pressure type of unit. In the third embodiment, the same numeral references correspond to the same parts as the embodiment of Fig. 1. The explanation of the same parts is omitted.

In the oxidation treatment unit of the embodiment, the normal-pressure gas-discharging pipe 19 forming the normal-pressure gas-discharging system 18 is connected to the gas-discharging pipe 13 of the reaction tube 2. The normal-pressure gas-discharging pipe 19 is connected to a gas-discharging duct of a factory gas-discharging system. The normal-pressure gas-discharging pipe 19 consists of a corrosion-resistant pipe.

A gas-discharging pressure in the factory gas-discharging system is set to be a slightly-reduced pressure, for example about -1000 Pa [-7.5 Torr] as a differential pressure with respect to the atmospheric pressure. The absolute type of pressure sensor 22, which detects the gas-discharging pressure, and the combination valve 20, which is adjustably caused to open and close and whose pressure is also adjustable, are provided in order in the normal-pressure gas-discharging pipe. The combination valve 20 is adapted to be controlled by the controlling part 36, based on the pressure detected by the absolute-pressure type of pressure sensor 22.

As the absolute-pressure type of pressure sensor 22, for example, a general pressure sensor that can detect a pressure within a range of 0 to 1330 hPa (0 to 1000 Torr) may be used. Alternatively, as the absolute-pressure type of pressure sensor 22, for example, a pressure sensor that can detect a pressure within a range of 800 to 1100 hPa may be used.

Regarding the absolute-pressure type of pressure sensor 22 and the combination valve 20, in order for them to endure the severe corrosion environment, gas-contact surfaces that may come in contact with the discharged gas are made of a corrosion-resistant material that is not metal, for example a corrosion-resistant resin, preferably a fluorine resin. In the case, it is preferable that the absolute-pressure type of pressure sensor 22 has a main body made of a fluorine resin or a ceramic and a pressure-receiving member made of a ceramic hermetically provided in the main body, similarly to the embodiment shown in Fig. 1.

A plurality of thermal processing units are connected to the factory gas-discharging system in a multiple manner. Thus, the suction force is not only weak but also variable. In order to solve the problem, the normal-pressure gas-discharging pipe 19 of the normal-pressure gas-discharging system 18 is provided with a multi-step type of ejector 40. The multi-step type of ejector 40 consists of, for example three ejector-elements 40a, 40b and 40c that are connected in a serial manner. A downstream part of the normal-pressure gas-discharging pipe 19 branches to be connected to the respective ejector-elements 40a, 40b and 40c.

Air or an inert gas such as nitrogen gas N₂ as a working gas is introduced into the first ejector-element 40a at a predetermined flow rate controlled by an electro-pneumatic regulator 41. Thus, the discharged gas from the normal-pressure gas-discharging pipe 19 is sucked by the first ejector-element 40a.

The gas discharged from the first ejector-element 40a is introduced into the second ejector-element 40b. Thus, the discharged gas from the normal-pressure gas-discharging pipe 19 is further sucked. Similarly, the gas discharged from the second ejector-element 40b is introduced into the third ejector-element 40c. Thus, the discharged gas from the normal-pressure gas-discharging pipe 19 is further sucked. Therefore, an amount of the gas discharged through the respective ejector-elements 40a, 40b and 40c increases stepwise. The discharged gas from the final (third in the embodiment shown in the drawing) ejector-element 40c is discharged to the factory gas-discharging system.

The electro-pneumatic regulator 41 is adapted to be controlled by the controlling part 36, based on the pressure detected by the absolute-pressure type of pressure sensor 22, in such a manner that the discharging-pressure in the normal-pressure gas-discharging pipe 19 coincides with a predetermined pressure. According to the above multi-step type of ejector 40, for example by supplying air or nitrogen gas as a working gas at a flow rate of 40 liter/min, a reduced-pressure gas-discharging operation of -133 hPa [-100 Torr] can be achieved.

Thus, according to the oxidation treatment unit of the embodiment, since the oxidation treatment unit comprises the multi-step type of ejector 40, even if there is a change of atmospheric pressure, the discharging pressure can be stably controlled to a vicinity of atmospheric pressure at any time. In addition, the multi-step type of ejector 40 has a multi-step structure, a discharging capacity exceeding the change of atmospheric pressure can be achieved with a small consumption amount of the gas. Furthermore, since the amount of the gas supplied through the electro-pneumatic regulator 41 to the multi-step type of ejector 40 is adjustable, a more energy-efficient system can be provided.

In the embodiment of Fig. 4, the pressure sensor 22 is absolute-pressure type, but may be different-pressure type. If a different-pressure type of pressure sensor is used, preferably, similarly to the embodiment of Fig. 3, the atmospheric pressure is detected by an absolute-pressure type of pressure sensor (atmospheric-pressure sensor), a signal therefrom is inputted into the controller, and a set differential pressure is adjusted.

As described above, the embodiments of the invention were explained in detail with reference to the drawings. However, this invention is not limited to the above embodiments, but may be changed or modified variously within a scope not away from the point of the invention. For example, in the above embodiments, the processing furnace is a vertical furnace, but could be a horizontal furnace. In addition, the processing furnace is a batch-type furnace, but could be a single-type furnace.

An object to be processed is not limited to the semiconductor wafer, but could be an LCD substrate or a glass substrate.

The water-vapor supplying means is not limited to burning-type means, but could be carburetor-type means, catalytic-type means or boiling-type means.

In addition, in the embodiments, the invention is applied to the oxidation treatment units. However, in addition to the oxidation treatment unit, the invention is applicable to a diffusion treatment unit, a CVD treatment unit, an annealing unit, a composite type of unit thereof, and so on.

Furthermore, instead of using the outer burning unit, hydrogen and oxygen may be introduced into the processing furnace to react with each other.

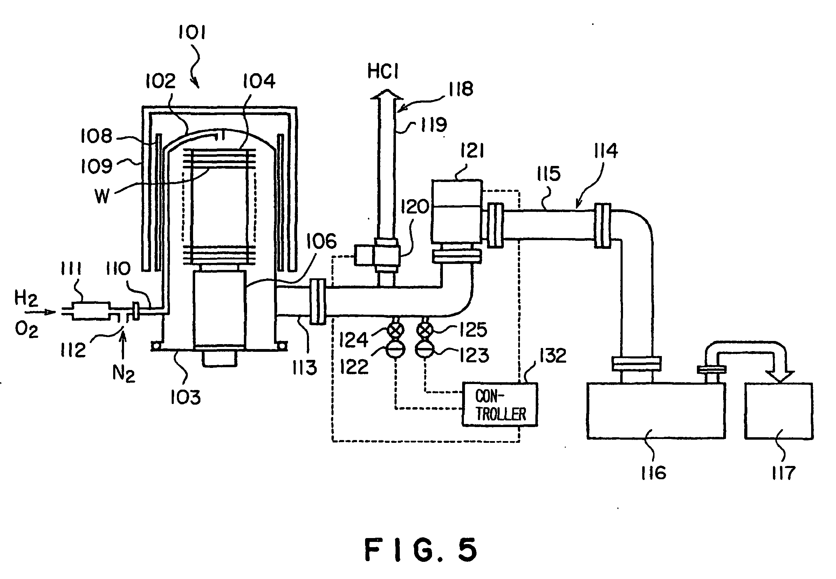

Next, Fig. 5 is a view showing a structure of an oxidation treatment unit of a fourth embodiment according to the invention. The oxidation treatment unit (a thermal processing unit) of the embodiment is formed not only as a normal-pressure type of unit but also as a reduced-pressure type of unit, by which a treatment can be carried out under a reduced pressure. In Fig. 5, a processing furnace 101, which is vertical and batch type, is adapted to contain semiconductor wafers W as objects to be processed, and to conduct a heat treatment to the semiconductor wafers W at a high temperature suchas about 850°Cwhilewater vapor as a process gas is supplied thereinto. The processing furnace 101 has a reaction tube (processing container) 102, whose upper end is closed, whose lower end is open, which has a longitudinal cylindrical shape and a heat resistance, and which is made of for example quartz.

The reaction tube 102 is adapted to form the processing furnace 101 with a high airtightness when an opening at a lower end thereof as a furnace opening is hermetically closed by a lid 103. A wafer-boat 104, which is made of for example quartz, as a substrate holder for holding many, for example about 150 horizontal semiconductor wafers W in a vertical tier-like manner at intervals, is placed on the lid 103 via a heat insulating cylinder 106.

The lid 103 is adapted to load (convey) the wafer boat 104 into the processing furnace 101, unload (convey) the wafer boat 104 from the processing furnace 101, and open and close the furnace opening, by means of an elevating mechanism not shown. A heater 108 that can heat and control the inside of the processing furnace to a predetermined temperature, for example 300 to 1000 °C, is provided around the reaction tube 102. The heater 108 is surrounded by a cooling jacket 109.

A suitable number of gas-introducing pipes 110 is provided at a lower portion of the reaction tube 102. One of the gas-introducing pipes 110 is connected to a burning unit 111 that generates water vapor by a burning reaction between hydrogen gas H₂ and oxygen gas O₂ and that supplies the water vapor as process-gas supplying means (water-vapor supplying means). The others of the gas-introducing pipes are respectively connected to gas sources that supply other process gases such as nitrogen oxide gas NO, dinitrogen oxide gas N₂O and hydrogen chloride gas HCl, or inert gas such as N₂ (omitted in the drawings).

A gas-discharging pipe (pipe-port) 113 is integrally provided at a lower side wall of the reaction tube 102 for discharging gas present inside the reaction tube 102. A gas-discharging pipe 115 forming a reduced-pressure gas-discharging system 114 is connected to the gas-discharging pipe 113. The lid 103 is made of metal (mainly made of stainless-steel). However, a coating treatment is conducted to a gas-contact surface of the lid, which may be subjected to high-temperature environment in the processing furnace and to the process gas, in order to prevent corrosion of a part made of metal and metal contamination of an object to be processed that may be caused by a part made of metal. Herein, a chromate film, which is a kind of ceramics, is coated on the gas-contact surface. In addition, a coating treatment is conducted to an inside surface of the gas-discharging pipe 113, in order to prevent by-products from attaching thereto when the by-products are cooled. Herein, a chromate film which has a high heat-resistance, or a fluorine resin film is coated thereon.

The gas-discharging pipe 115 consists of a pipe having a large inside diameter, for example of about 3 inch, so that a reduced-pressure gas-discharging operation can be conducted under a high degree of vacuum. In addition, the pipe forming the gas-discharging pipe 115 is corrosion-resistant. For example, if the pipe is made of metal (preferably, made of stainless-steel), the inside surface of the pipe is coated with a film of a fluorine resin that is a corrosion-resistant resin. A pressure-reducing pump (vacuum pump) 116 that can create a vacuum of for example about -1 Pa at the maximum in the processing furnace 101 is connected to a downstream end of the gas-discharging pipe 115. A harm-removing unit 117 is connected to a downstream side of the pressure-reducing pump 116. The inside surface of a pipe to the harm-removing unit 117 is also coated with a film of a fluorine resin. It is preferable that the pressure-reducing pump 116 is for example a dry-sealed vacuum pump.

A normal-pressure gas-discharging pipe 119, which forms a normal-pressure gas-discharging system 118 communicating with a gas-discharging duct (not shown) of a factory gas-discharging system including a harm-removing unit and/or a gas-discharging blower, branches off on the way of the gas-discharging pipe 115. Thus, an operation under a normal pressure or a slightly reduced pressure can be conducted. The normal-pressure gas-discharging pipe 119 is a pipe made of metal, preferably a pipe made of stainless-steel, whose inside surface is coated with a film of fluorine resin that is a corrosion-resistant resin, similarly to the gas-discharging pipe 115. Preferably, heating means such as a resistant heating element is arranged around the outside peripheries of the gas-discharging pipe 115 and the normal-pressure gas-discharging pipe 119, in order to evaporate moisture in the pipes that may cause corrosion.

In the normal-pressure gas-discharging system 118 and the reduced-pressure gas-discharging system 114, combination valves 120 and 121, which are adjustably caused to open and close and whose pressures are also adjustable, are provided respectively. In the reduced-pressure gas-discharging system 114, the combination valve 121 is mounted in the gas-discharging pipe 115 at a downstream portion with respect to the branching-connecting portion of the normal-pressure gas-discharging pipe 119. For example, each of the combination valves 120, 121 may convert an electric signal into an air pressure, in order to control the position of a valve body (not shown). In addition, each of the combination valves 120, 121 has an O-shaped ring (not shown) at a seating portion for the valve body, so that the combination valves 120, 121 can shut off. Portions of the combination valves 120, 121 that may come in contact with the discharged gas are made of a corrosion-resistance material such as a fluorine resin. Alternatively, if the combination valves 120, 121 are made of metal, the gas-contact surfaces that may come in contact with the discharged gas are coated by a fluorine resin film.

A pressure sensor 122 that detects a gas-discharging pressure while a treatment is carried out under a normal pressure and a pressure sensor 123 that detects a gas-discharging pressure while a treatment is carried out under a reduced pressure (while the gas is discharged under a reduced pressure) are respectively provided via air-pressure-control type of valves 124 and 125 at upstream portions of the gas-discharging pipe 115 with respect to the combination valve 121 for the treatment under a reduced pressure. Regarding the pressure sensors 122, 123, each gas-contact surface that may come in contact with the discharged gas is made of a fluorine resin, in order to enable the pressure sensors to be used in severe corrosion environment wherein moisture H₂O and a corrosive gas such as HCl exit.

The combination valves 120 and 121, which are provided in the normal-pressure gas-discharging system 118 and in the reduced-pressure gas-discharging system 114, respectively, are adapted to be controlled by the common controlling part (controller) 132, based on the pressures detected by the pressure sensors 122 and 123. In detail, for an operation under a normal pressure, the controlling part 132 causes the combination valve 120 in the normal-pressure gas-discharging system 118 to open, and controls the same based on the pressure detected by the pressure sensor 122 that is provided for the operation under a normal pressure. In addition, for an operation under a reduced pressure, the controlling part 132 causes the combination valve 121 in the reduced-pressure gas-discharging system 114 to open, and controls the same based on the pressure detected by the pressure sensor 123 that is provided for the operation under a reduced pressure. That is, two control systems can be achieved.

The oxidation treatment unit consisting of the above compositions has a leak-tight structure in which the gas can be discharged at a highly reduced pressure. For example, sealing means such as an O-shaped ring is provided at each connecting part in the gas-discharging system from the processing furnace 101. In addition, the thermal processing unit is adapted to automatically carry out a desired thermal processing method, by controlling the burning unit 111, the heater 108, the controlling part 132 for the combination valves 120 and 121, and so on through a controlling unit (not shown) in which a program recipe for the desired thermal processing method has been inputted in advance.

As a method of coating the chromate film, for example, a method of forming a chromate film described in Japanese Patent Laid-Open publication number 63-317680 may be used. In this method, slurry is adjusted by adding SiO₂ and Al₂O₃ powder into a chromic anhydride solution, and the slurry is applied onto a metal surface and then heated to form a porous film. The porous film is dunk in a chromic anhydride solution into which 10 weight % or less of ammonium chromate or ammonium bichromate is added, and then subjected to a heating treatment. By repeating the chromate dunking (dipping) treatment and the heating treatment, a chromate film having a rich heat-resistance and a rich corrosion-resistance can be obtained.

As a fluorine resin with which the gas-discharging pipes 115, 119 and the valves 120, 121 are coated, for example, PTFE = polytetrafluoroethylene (ethylene tetrafluoride resin), PFA = tetrafluoroethylene-perfluoroalkylvinylether copolymer (perfluoroalkoxy resin), ETFE = tetrafluoroethylene-ethylene copolymer (ethylene tetrafluoride-ethylene copolymer resin), and so on may be used. A method of coating the fluorine resin onto the gas-contact surfaces of the gas-discharging system may be spraying, dipping, applying with a brush, lining, and so on. By means of the fluorine resin coating, corrosion of the gas-discharging system is prevented, and attachment of by-products is also prevented because of surface smoothness thereof.

Next, an operation of the above oxidation treatment unit (a thermal processing method) is explained. At first, the inside of the processing furnace 101 is open to the atmosphere, and is heated and controlled at a predetermined temperature such as 300 °C by the heater 108. The wafer boat 104 holding many semiconductor wafers W is loaded into the processing furnace 101. The furnace opening of the processing furnace 101 is hermetically closed by the lid 103. After that, the pressure in the processing furnace 101 is reduced by a vacuuming operation of the reduced-pressure gas-discharging system 114. Preferably, the pressure-reducing or vacuuming operation includes a cycle-purging step. During the loading step and the cycle-purging step, an inert gas such as N₂ is supplied into the processing furnace 101 in order to prevent that a natural oxidation film is formed on surfaces of the semiconductor wafers W. On the other hand, if the N₂ is 100 %, the surfaces of the semiconductor wafers W may be nitrified. The nitrified surfaces are difficult to be oxidized at a subsequent oxidizing step. Thus, a small amount of oxygen, for example about 1 % of oxygen is supplied during the loading step and the cycle-purging step.

The cycle-purging step is carried out by repeating supply and stop of the inert gas such as N₂ by turns while the inside of the processing furnace 101 is vacuumed. In the case, the gas-discharging system is switched into the reduced-pressure gas-discharging system 114 by means of the combination valve 121. In addition, while the vacuum pump 116 is in operation, a pressure (a pressure in the tube = a pressure in the furnace 101) is detected by the pressure sensor 123. In addition, gas in the processing furnace 101 is discharged through a control of the combination valve 121 in such a manner that a pressure in the processing furnace 101 becomes a predetermined pressure such as about -1 Pa. In the reduced-pressure gas-discharging condition, an inert gas such as N₂, whose flow rate is controlled at a predetermined rate, is intermittently supplied by repeating opening and shutting an inert-gas-supplying valve (not shown). Thus, the cycle-purging step is carried out, the pressure in the processing furnace 101 is rapidly reduced, and the gas in the processing furnace 101 is replaced with the inert gas sufficiently. That is, rapid reduction of the pressure (shortening of a time until a predetermined vacuum is created) and gas-replacement can be achieved by the cycle-purging step.

Next, in the above reduced-pressure gas-discharging condition, the atmosphere in the processing furnace 101 is heated to a predetermined process temperature such as 850 °C via a control of the heater 108. As the gas-discharging system is switched into the normal-pressure gas-discharging system 118 by means of the combination valve 120, the pressure in the processing furnace 101 is controlled to a normal pressure (a pressure reduced by about 1 Torr) or a slightly reduced pressure (a pressure reduced by about 100 to 200 Torr). In the state, a recovery step (a step for stabilizing semiconductor-wafer temperature) is carried out, and then a predetermined heating process such as an HCl oxidation treatment is carried out. The heating treatment is carried out under a slightly reduced pressure, by supplying oxygen gas O₂ and hydrogen gas H₂ into the burning unit 111 to cause them to burn, and by supplying water vapor generated in the burning unit 111 into the processing furnace 101 together with hydrogen chloride gas HCl and an inert gas such as N₂.

After the heating processing step is completed, the gas-discharging system is switched into the reduced-pressure gas-discharging system 114 (automatic switching), so that the inside of the processing furnace 101 is vacuumed again to reduce the pressure therein. After that, through a control of the heater 108, a temperature of the inside of the processing furnace 101 is reduced to a predetermined temperature such as about 300 °C. At the same time, the pressure in the processing furnace 101 is returned to a normal pressure, the wafer boat 104 is unloaded from the processing furnace 101, and a cooling step (wherein the semiconductor wafers are cooled to a conveyable temperature) is carried out. Preferably, the second pressure-reducing and vacuuming operation after completing the heating processing step also includes a cycle-purging step.

As described above, the semiconductor wafers W are contained in the processing furnace 101 that have been already heated to a predetermined temperature, the inside atmosphere in the processing furnace 101 is heated to a predetermined process temperature, and water vapor as a process gas is supplied in order to thermally process the semiconductor wafers W, wherein the heating step of the inside atmosphere is carried out under a reduced pressure. Thus, the semiconductor wafers W can be heated to the predetermined process temperature under a condition wherein oxidation species are excluded. Thus, it can be prevented that a natural oxidation film is formed during the heating step, so that a very-thin oxidation film whose quality is excellent can be formed.

In addition, not only before the predetermined heat treatment step but also after the same step, the inside in the processing furnace 101 is vacuumed to reduce the pressure therein. Thus, surplus oxidation species are sufficiently excluded except for in the desired heat treatment step, so that it can be sufficiently prevented that a natural oxidation film is formed. Thus, a very-thin oxidation film whose thickness is uniform and whose quality is uniform and excellent can be formed. For example, an SiO₂ film whose thickness is for example about 2 nm can be formed.

If the step of reducing the pressure in the processing furnace 101 or of vacuuming the processing furnace 101 includes what is called a cycle-purging step, rapid pressure-reduction and gas-replacement can be achieved, which can improve throughput.

In addition, the heat treatment unit comprises: the burning unit 111 that is water vapor supplying means for supplying the water vapor into the processing furnace 101; the normal-pressure gas-discharging system 118 that discharges the gas from the processing furnace 101 during the heat treatment step under a minute differential pressure or a minute reduced pressure; and the reduced-pressure gas-discharging system 114 that can vacuum the inside of the processing furnace 101 before and after the heat treatment step; wherein the switching operation between the normal-pressure gas-discharging system 118 and the reduced-pressure gas-discharging system 114 are carried out by means of the combination valves 120 and 121. Thus, the above thermal processing method can be carried out surely and easily.

Thus, the reduced-pressure type of oxidation treatment unit, by which a treatment can be carried out under a reduced pressure, is for supplying the process gas into the processing furnace 101 that contains the semiconductor wafers w and for thermally processing the semiconductor wafers W at a predetermined process temperature. Then, the reduced-pressure type of oxidation treatment unit has: the normal-pressure gas-discharging system 118 for discharging the gas from the processing furnace 101 at a predetermined discharging-pressure; the reduced-pressure gas-discharging system 114 for discharging the gas from the processing furnace 101 at another discharging-pressure lower than that by the normal-pressure gas-discharging system 118; the combination valves 120 and 121 provided in the normal-pressure gas-discharging system 118 and the reduced-pressure gas-discharging system 114, respectively, and adjustably caused to open and close, the pressures of the valves being also adjustable; the absolute-pressure type of pressure sensors 122 and 123 that detect the discharging-pressure; and the controller 132 that controls the combination valves 120 and 121 based on the pressures detected by the pressure sensors 122 and 123.

Thus, an oxidation treatment under a normal pressure or a slightly reduced pressure by means of the normal-pressure gas-discharging system 118 and a cycle-purging operation, a CVD treatment under a reduced pressure or the like by means of the reduced-pressure gas-discharging system 114 can be serially conducted. In the normal-pressure gas-discharging system 118, a stable control can be achieved without necessity of introducing atmospheric air or introducing any inert gas. In addition, the structure of the gas-discharging system is simplified, and running-costs for the inert gas such as N₂ become unnecessary, so that reduction of costs for the whole unit is achieved.

Especially, since the absolute-pressure type of pressure sensors 122 and 123 are used as the pressure sensor in the normal-pressure gas-discharging system 118 and the pressure sensor in the reduced-pressure gas-discharging system 114, a stable absolute-pressure control in a vicinity of the atmospheric pressure and a stable absolute-pressure control under a reduced pressure can be achieved, without disturbance caused by change in the atmospheric pressure based on the meteorological condition. Thus, an oxide film having a uniform thin film-thickness can be formed at any time.

In addition, the gas-contact surface of the lid 103 made of metal is coated with a chromate film in order to prevent corrosion of the lid 103 and metal contamination of the wafer W that may be caused by the lid 103. Thus, it becomes unnecessary to take expensive measures, such as of covering by a quartz cover a metal part that may be subjected to the high-temperature environment in the furnace or of locally supplying an inert gas to prevent the gas in the furnace from coming in contact with the metal part. That is, inexpensively, the corrosion resistance may be improved and the metal contamination may be prevented.

Furthermore, the inside surface of the gas-discharging pipe 13, which is an outlet of the reaction tube 2, and the gas-contact surfaces of the gas-discharging pipes 115, 119 and the combination valves 120, 121 are coated with the fluorine resin. Thus, the attachment of by-products may be prevented and a stable corrosion resistance may be secured. Thus, a load at a maintenance operation may be reduced.

As described above, the embodiment of the invention was explained in detail with reference to the drawing. However, this invention is not limited to the above embodiment, but may be changed or modified variously within a scope not away from the point of the invention. For example, in the above embodiment, the processing furnace is a vertical furnace, but could be a horizontal furnace. In addition, the processing furnace is a batch-type furnace, but could be a single-type furnace.

An object to be processed is not limited to the semiconductor wafer, but could be an LCD substrate or a glass substrate.

The water-vapor supplying means is not limited to burning-type means, but could be carburetor-type means, catalytic-type means or boiling-type means.

In addition, in the embodiment, the invention is applied to the oxidation treatment unit. However, in addition to the oxidation treatment unit, the invention is applicable to a diffusion treatment unit, a CVD treatment unit, an annealing unit, a composite type of unit thereof, and so on.

As described above, the embodiments of the invention were explained in detail with reference to the drawings. However, this invention is not limited to the above embodiments, but may be changed or modified variously within a scope not away from the point of the invention. For example, in the above embodiments, the processing furnace is a vertical furnace, but could be a horizontal furnace. In addition, the processing furnace is a batch-type furnace, but could be a single-type furnace.

An object to be processed is not limited to the semiconductor wafer, but could be an LCD substrate or a glass substrate.

The water-vapor supplying means is not limited to burning-type means, but could be carburetor-type means, catalytic-type means or boiling-type means.

In addition, in the embodiments, the invention is applied to the oxidation treatment units. However, in addition to the oxidation treatment unit, the invention is applicable to a diffusion treatment unit, a CVD treatment unit, an annealing unit, a composite type of unit thereof, and so on.

Furthermore, instead of using the outer burning unit, hydrogen and oxygen may be introduced into the processing furnace to react with each other.

In addition, the reduced-pressure gas-discharging system and the normal-pressure gas-discharging system may be combined in such a manner that they can be alternatively selected by means of a switching valve.

## Claims

1. A thermal processing unit comprising;
a processing furnace (11),
gas-supplying means (10) that supplies a process gas into the processing furnace (11),
heating means (8) that heats an inside of the processing furnace to a predetermined process-temperature,
a normal-pressure gas-discharging system (18) for discharging gas from the processing furnace at a predetermined discharging-pressure that is near to an atmospheric pressure,
a first combination valve (20) provided in the normal-pressure gas-discharging system (18), the first combination valve (20) being adjustably caused to open and close, a pressure of the gas through the first combination valve (20) being also adjustable,
a first pressure sensor (22) that detects a discharging-pressure in the normal-pressure gas-discharging system (18),
a reduced-pressure gas-discharging system (14) for discharging gas from the processing furnace (1) at another predetermined discharging-pressure that is lower than the atmospheric pressure,
a second combination valve (21) provided in the reduced-pressure gas-discharging system (14), the second combination valve (21) being adjustably caused to open and close, a pressure of the gas through the second combination valve (21) being also adjustable,
a second pressure sensor (23) that detects a discharging-pressure in the reduced-pressure gas-discharging system (14), and
a common controller (32) that controls the first combination valve (20) based on the pressure detected by the first pressure sensor (22) and that controls the second combination valve (21) based on the pressure detected by the second pressure sensor (23),
wherein said first and second combination valves (20, 21) and said common controller (32) enable said thermal processing unit to be switched between the normal-pressure gas-discharging system (18) and the reduced-pressure gas-discharging system (14) during a single thermal processing operation;
wherein a gas-contact surface in the first pressure sensor (22) that may come in contact with the discharged gas is made of a corrosion-resistant material that is not metal,
a gas-contact surface in the second pressure sensor (23) that may come in contact with the discharged gas is made of a corrosion-resistant material that is not metal.

2. A thermal processing unit according to claim 1, wherein:
the first pressure sensor (22) is differential-pressure type.

3. A thermal processing unit according to claim 1, wherein:
the first pressure sensor (22) is absolute-pressure type.

4. A thermal processing unit according to claims 1 or 2, wherein:
the second pressure sensor (23) is differential-pressure type.

5. A thermal processing unit according to claims 1 or 2, wherein:
the second pressure sensor (23) is absolute-pressure type.

6. A thermal processing unit according to one of the preceding claims, wherein:
each of the first pressure sensor (22) and the second pressure sensor (23) has:
a main body made of a fluorine resin or a ceramic; and
a pressure-receiving member hermetically provided in the main body and made of a ceramic.

7. A thermal processing unit according to one of the preceding claims
wherein the processing furnace (1) has a processing-furnace member made of metal whose gas-contact surface is coated by a chromate film in order to prevent corrosion and contamination of an object to be processed, the gas-contact surface being subjected to environment in the processing furnace.

8. A thermal processing unit according to claim 7, wherein:
the gas-discharging systems (14, 18) each have a gas-discharging-system member made of metal whose gas-contact surface is coated by a fluorine resin film in order to prevent corrosion and attachment of by-products.

9. A thermal processing unit according to claim 8, wherein:
the gas-discharging-system member made of metal has a pipe (15, 19) and/or a valve.

10. A thermal processing unit according to claims 7, 8 or 9, wherein:
the gas-discharging pipe (15, 19) has an inside surface coated in order to prevent corrosion and attachment of by-products.

## Patentansprüche

1. Thermische Verarbeitungseinheit, die folgendes umfaßt:
einen Verarbeitungsofen (11),
Gaszufuhrmittel (10), die ein Prozeßgas in den Verarbeitungsofen (11) zuführen, Heizmittel (8), die das Innere des Verarbeitungsofens auf eine vorbestimmte Prozeßtemperatur heizen,
ein Normaldruck-Gasauslaßsystem (18) zum Auslassen von Gas aus dem Verarbeitungsofen bei einem vorbestimmten Auslaßdruck, der nahe dem Atmosphärendruck liegt,
ein erstes Kombinationsventil (20), welches in dem Normaldruck-Gasauslaßsystem (18) vorgesehen ist, wobei auf einstellbare Weise veranlaßt wird, daß sich das erste Kombinationsventil (20) öffnet und schließt, wobei ein Druck des Gases durch das erste Kombinationsventil (20) hindurch ebenfalls einstellbar ist,
einen ersten Drucksensor (22), der einen Auslaßdruck in dem Normaldruck-Gasauslaßsystem (18) detektiert,
ein Verringerter-Druck-Gasauslaßsystem (14), zum Auslassen von Gas aus dem Verarbeitungsofen (1) bei einem anderen vorbestimmten Auslaßdruck, der niedriger als der Atmosphärendruck ist,
ein zweites Kombinationsventil (21), welches in dem Verringerter-Druck-Gasauslaßsystem (14) vorgesehen ist, wobei auf einstellbare Weise veranlaßt wird, daß sich das zweite Kombinationsventil (21) öffnet und schließt, und ein Druck des Gases durch das zweite Kombinationsventil (21) hindurch ebenfalls einstellbar ist, einen zweiten Drucksensor (23), der einen Auslaßdruck in dem Verringerter-Druck-Gasauslaßsystem (14) detektiert, und
eine gemeinsame Steuerung (32), die das erste Kombinationsventil (20) basierend auf dem durch den ersten Drucksensor (22) detektierten Druck steuert und die das zweite Kombinationsventil (21) basierend auf dem Druck, der durch den zweiten Drucksensor (23) detektiert wird, steuert,
wobei das erste und das zweite Kombinationsventil (20, 21) und die gemeinsame Steuerung (32) ermöglichen, daß die thermische Verarbeitungseinheit während einer einzigen thermischen Verarbeitungsoperation zwischen dem Normaldruck-Gasauslaßsystem (18) und dem Verringerter-Druck-Gasauslaßsystem (14) umgeschaltet wird,
wobei eine Gaskontaktfläche in dem ersten Drucksensor (22), die mit dem ausgelassenen Gas in Kontakt kommen kann, aus einem korrosionsbeständigen Material hergestellt ist, welches kein Metall ist, und
eine Gaskontaktfläche in dem zweiten Drucksensor (23), die mit dem ausgelassenen Gas in Kontakt kommen kann, aus einem korrosionsbeständigen Material hergestellt ist, das kein Metall ist.

2. Thermische Verarbeitungseinheit nach Anspruch 1, bei der der erste Drucksensor von der Differentialdruck-Art ist.

3. Thermische Verarbeitungseinheit nach Anspruch 1, bei der der erste Drucksensor (22) von der Absolutdruck-Art ist.

4. Thermische Verarbeitungseinheit nach Anspruch 1 oder 2, bei der der zweite Drucksensor (23) von der Differentialdruck-Art ist.

5. Thermische Verarbeitungseinheit nach Anspruch 1 oder 2, bei der der zweite Drucksensor (23) von der Absolutdruck-Art ist.

6. Thermische Verarbeitungseinheit nach einem der vorhergehenden Ansprüche, bei der der erste Drucksensor (22) und der zweite Drucksensor (23) jeweils
einen Hauptkörper haben, der aus einem Fluor-Kunstharz oder einer Keramik besteht; und
ein druckaufnehmendes Element haben, welches hermetisch in dem Hauptkörper vorgesehen ist und aus einer Keramik besteht.

7. Thermische Verarbeitungseinheit nach einem der vorhergehenden Ansprüche, bei der der Verarbeitungsofen (1) ein Verarbeitungsofen-Element hat, welches aus Metall besteht, dessen Gaskontaktfläche mit einem Chromat-Film beschichtet ist, um Korrosion und eine Kontamination eines zu verarbeitenden Objektes zu verhindern, wobei die Gaskontaktfläche der Umgebung in dem Verarbeitungsofen ausgesetzt ist.

8. Thermische Verarbeitungseinheit nach Anspruch 7, bei der die Gasauslaßsysteme (14, 18) jeweils ein Gasauslaßsystem-Element haben, welches aus Metall hergestellt ist, dessen Gaskontaktfläche mit einer Fluor-Kunstharzschicht beschichtet ist, um Korrosion und Anhaften von Nebenprodukten zu verhindern.

9. Thermische Verarbeitungseinheit nach Anspruch 8, bei der das aus Metall bestehende Gasauslaßsystem-Element ein Rohr (15, 19) und/oder ein Ventil aufweist.

10. Thermische Verarbeitungseinheit nach Anspruch 7, 8 oder 9, bei der das Gasauslaßrohr (15, 19) eine Innenfläche hat, die beschichtet ist, um Korrosion und ein Anhaften von Nebenprodukten zu verhindern.

## Revendications

1. Unité de traitement thermique comportant :
un four de traitement (11),
des moyens d'alimentation en gaz (10) qui alimentent un gaz de traitement dans le four de traitement (11),
des moyens de chauffage (8) qui chauffent l'intérieur du four de traitement jusqu'à une température de traitement prédéterminée,
un système de décharge de gaz à pression normale (18) pour décharger un gaz depuis le four de traitement à une pression de décharge prédéterminée qui est proche d'une pression atmosphérique,
une première vanne mixte (20) agencée dans le système de décharge de gaz à pression normale (18), la première vanne mixte (20) étant amenée de manière ajustable à s'ouvrir et à se fermer, une pression du gaz à travers la première vanne mixte (20) étant également ajustable,
un premier capteur de pression (22) qui détecte une pression de décharge dans le système de décharge de gaz à pression normale (18),
un système de décharge de gaz à pression réduite (14) pour décharger un gaz depuis le four de traitement (1) à une autre pression de décharge prédéterminée qui est inférieure à la pression atmosphérique,
une seconde vanne mixte (21) agencée dans le système de décharge de gaz à pression réduite (14), la seconde vanne mixte (21) étant amenée de manière ajustable à s'ouvrir et se fermer, une pression du gaz à travers la seconde vanne mixte (21) étant également ajustable,
un second capteur de pression (23) qui détecte une pression de décharge dans le système de décharge de gaz à pression réduite (14), et
un contrôleur commun (32) qui commande la première vanne mixte (20) sur la base de la pression détectée par le premier capteur de pression (22) et qui commande la seconde vanne mixte (21) sur la base de la pression détectée par le second capteur de pression (23),
dans laquelle lesdites première et seconde vannes mixtes (20, 21) et ledit contrôleur commun (32) permettent à ladite unité de traitement thermique d'être permutée entre le système de décharge de gaz à pression normale (18) et le système de décharge de gaz à pression réduite (14) pendant une opération de traitement thermique unique,
dans laquelle une surface de contact de gaz dans le premier capteur de pression (22) qui peut venir en contact avec le gaz déchargé est constituée d'un matériau résistant à la corrosion qui n'est pas un métal,
une surface de contact de gaz dans le second capteur de pression (23) qui peut venir en contact avec le gaz déchargé est constituée d'un matériau résistant à la corrosion qui n'est pas un métal.

2. Unité de traitement thermique selon la revendication 1, dans laquelle :
le premier capteur de pression (22) est d'un type à pression différentielle.

3. Unité de traitement thermique selon la revendication 1, dans laquelle :
le premier capteur de pression (22) est d'un type à pression absolue.

4. Unité de traitement thermique selon la revendication 1 ou 2, dans laquelle :
le second capteur de pression (23) est d'un type à pression différentielle.

5. Unité de traitement thermique selon la revendication 1 ou 2, dans laquelle :
le second capteur de pression (23) est d'un type à pression absolue.

6. Unité de traitement thermique selon l'une quelconque des revendications précédentes, dans laquelle :
chacun des premier capteur de pression (22) et second capteur de pression (23) a :
un corps principal constitué d'une résine fluorée ou d'une céramique, et
un élément de réception de pression agencé hermétiquement dans le corps principal et constitué d'une céramique.

7. Unité de traitement thermique selon l'une quelconque des revendications précédentes
dans laquelle le four de traitement (1) a un élément de four de traitement constitué d'un métal dont la surface de contact de gaz est revêtue d'un film de chromate afin d'empêcher une corrosion et une contamination d'un objet à traiter, la surface de contact de gaz étant soumise à un environnement dans le four de traitement.

8. Unité de traitement thermique selon la revendication 7, dans laquelle :
les systèmes de décharge de gaz (14, 18) ont chacun un élément de système de décharge de gaz constitué d'un métal dont la surface de contact de gaz est revêtue d'un film de résine fluorée afin d'empêcher une corrosion et une fixation de sous-produits.

9. Unité de traitement thermique selon la revendication 8, dans laquelle :
l'élément de système de décharge de gaz constitué d'un métal a un tuyau (15, 19) et/ou une vanne.

10. Unité de traitement thermique selon les revendications 7, 8 ou 9, dans laquelle :
le tuyau de décharge de gaz (15, 19) a une surface intérieure revêtue afin d'empêcher une corrosion et une fixation de sous-produits.
